# EUROPEAN PATENT APPLICATION

(11) **EP 2 239 777 A2**
(43) Date of publication of application: **13.10.2010**
(21) Application number: 10157620.5
(22) Date of filing: 24.03.2010
(51) Int. Cl.: H01L 27/146

(54) **Imaging device**

(30) Priority: 27.03.2009 JP 2009080267
(71) Applicant: Fujifilm Corporation, Minato-ku Tokyo (JP)
(72) Inventor: Ota, Motoari, Kanagawa (JP)
(74) Representative: Höhfeld, Jochen

(57) **Abstract**

An imaging device includes: a plurality of pixel portions including color filters and photoelectric conversion portions, respectively, each of the photoelectric conversion portions generating charge according to light incident thereon, the color filters being provided on a light incidence side of the respective photoelectric conversion portions, a distance between the photoelectric conversion portions and the color filters being shorter than or equal to 3 µm; and a separation wall which is provided between adjoining ones of the color filters and separates the color filters from each other.

## Description

### CROSS-REFERENCE TO RELATED APPLICATIONS

This application claims the benefit of Japanese Patent Application JP 2009-080267, filed March 27, 2009, the entire content of which is hereby incorporated by reference, the same as if set forth at length.

### FIELD OF THE INVENTION

The present invention relates to an imaging device which generates charges according to incident light in photoelectric conversion portions.

### BACKGROUND OF THE INVENTION

Solid-state imaging devices of conventional CCD image sensors etc. are provided with a semiconductor substrate in which photodiodes are formed and a signal reading circuit such as charge transfer channels (including wiring layers) for transfer of charges generated in the photodiodes. The signal reading circuit is formed on the light-incidence-side surface of the semiconductor substrate.

At present, an imaging device is available which is provided with bottom electrodes formed on a substrate (e.g., silicon substrate), a photoelectric conversion layer laid on the bottom electrodes and made of materials including an organic material, and a transparent top electrode formed on the photoelectric conversion layer. Color filters, which are an arrangement of color patterns, are formed on the top electrode to transmit light components of prescribed colors (wavelength ranges). This imaging device is called a stack-type imaging device because the photoelectric conversion layer is laid on the substrate. In the stack-type imaging device, charges generated in the photoelectric conversion layer are transferred from the bottom electrodes to the substrate side and read out by a signal reading circuit. A stack-type imaging device is disclosed in JP-A-2008-252004, for example.

A solid-state imaging device has also been proposed in which incident light is applied through the back surface of a semiconductor substrate that is opposite to its front surface on which a signal reading circuit is formed and detected by photodiodes formed in the semiconductor substrate. And charges generated by the photodiodes are read out by the signal reading circuit. The solid-state imaging device having this configuration, which is in contrast to the previous imaging device in which light is incident on the front surface of the semiconductor substrate on which the signal reading circuit is formed, is called a back-illumination-type imaging device. A back-illumination-type imaging device is disclosed in JP-A-2008-205256.

The stack-type imaging device and the back-illumination-type imaging device are both advantageous over previoussolid-stateimaging devicesin being capable of attaining high sensitivity by increasing the photodetection area and hence the photoelectric conversion efficiency.

These imaging devices are provided with the color filters on the light illumination side. The stack-type imaging device is configured in such a manner that the bottom electrodes are connected to the front surface of the semiconductor substrate by electrically conductive connecting portions and charges are read out by signal reading portions formed in the semiconductor substrate. Since only a planarization layer and an insulating layer are formed between the color filters and the photoelectric conversion layer, the distance between the color filters and the photoelectric conversion layer can be made small. In the back-illumination-type imaging device, the color filters are formed on the back surface and the signal reading circuit is formed on the front surface of the semiconductor substrate. Since only a planarization layer and an insulating layer are formed between the color filters and the photoelectric conversion layer, the distance between the color filters and the photoelectric conversion layer can be made small.

Therefore, with the configuration in which the photodetection area is large and the distance between the color filters to the photoelectric conversion layer or the photodiodes is short, the above imaging devices can increase the efficiency of transmission of incident light.

JP-A-2006-295125 discloses a solid-state imaging device which is provided with a semiconductor substrate, photodetecting elements formed on the semiconductor substrate in matrix form, and plural color filters formed in a layer that is located over the photodetecting elements. Gaps are formed between the plural color filters.

### SUMMARY OF THE INVENTION

However, imaging apparatus such as digital cameras to which the stack-type imaging device and the back-illumination-type imaging device are applied are increasingly required to be improved in optical characteristics and image quality and are also required to be increased further in transmission efficiency. In particular, in recent years, with the miniaturization of pixels which is a result of increase in the number of pixels, it has become necessary to increase the transmission efficiency in each pixel portion.

Furthermore, the stack-type imaging device and the back-illumination-type imaging device have room for improvement in terms of crosstalk (color contamination) which is a phenomenon that part of light incident on a pixel portion enters the photoelectric conversion portions of adjacent pixel portions.

An obj ect of the present invention is therefore to provide an imaging device capable of increasing the transmission efficiency further and reducing crosstalk.

An imaging device comprising:
plural pixel portions comprising color filters and photoelectric conversion portions, respectively, each of the photoelectric conversion portions generating charge according to light incident thereon, the color filters being provided on a light incidence side of the respective photoelectric conversion portions, a distance between the photoelectric conversion portions and the color filters being shorter than or equal to 3 µm; and
a separation wall which is provided between adjoining ones of the color filters and separates the color filters from each other.

The present inventors have found that forming a separation wall between the color filters makes it possible to further increase the efficiency of transmission of light in the photoelectric conversion portion of each pixel portion. As described above, in the stack-type imaging device and the back-illumination-type imaging device, the distance between the photoelectric conversion portions and the color filters can be made shorter (e.g., less than or equal to 5 µm) and the photodetection area can be made larger than in previous imaging devices in which charge transfer electrodes, etc. are provided between the photoelectric conversion port ions and the color filters. It has been thought that sufficiently high transmission efficiency has already been attained by the stack-type imaging device and the back-illumination-type imaging device because incident light that has passed through a color filter is prevented from entering regions other than the associated photoelectric conversion portion. Therefore, it has been thought that even if the pixel portions are separated from each other the transmission efficiency is not increased. The inventors have also found that the increase in transmission efficiency that is attained by providing the separation wall is larger when the distance between the photoelectric conversion portions and the color filters are shorter or the photodetection area of each pixel portion (pixel portion size) is smaller.

Furthermore, providing the separation wall also makes it possible to reduce crosstalk.

The invention can provide an imaging device capable of increasing the transmission efficiency further and reducing crosstalk.

### BRIEF DESCRIPTION OF THE DRAWINGS

Fig. 1 is a sectional view showing an example configuration of an imaging device.

Fig. 2 is a plan view of four pixel portions.

Figs. 3A and 3B show optical energy profiles that were obtained when light was incident on pixel portions of an imaging device without a separation wall and an imaging device with a separation wall.

Figs. 4A and 4B show optical energy distributions that were obtained in cross sections taken at a position that was 0.4 µm below the bottom surfaces of the color filters in the imaging devices of Figs. 3A and 3B.

Figs. 5A and 5B show optical energy distributions that were obtained in cross sections taken at a position that was 5.0 µm below the bottom surfaces of the color filters in the imaging devices of Figs. 3A and 3B.

Fig. 6 is a sectional view showing an example configuration of another imaging device.

Fig. 7 is a sectional view showing an example configuration of another imaging device.

Fig. 8 is a sectional view showing an example configuration of still another imaging device.

Fig. 9 is a sectional view showing an example configuration of yet another imaging device.

Fig. 10 is a sectional view showing an example configuration of a further imaging device.

### DETAILED DESCRIPTION OF THE INVENTION

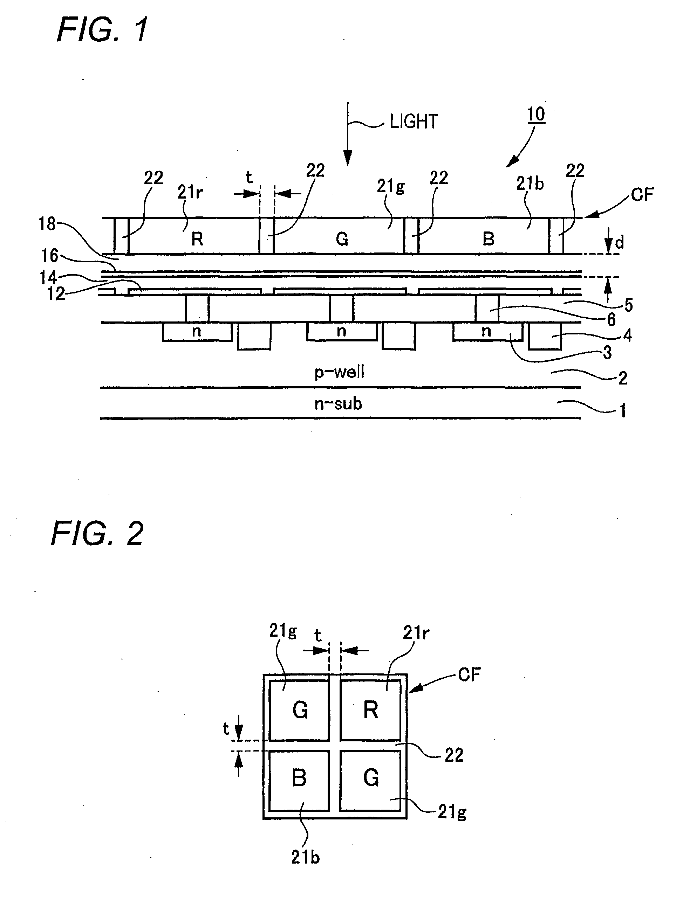

Fig. 1 is a schematic sectional view showing an example configuration of an imaging device. The imaging device 10 is generally configured in such a manner that plural pixel portions are provided on a substrate and color filters (CF) are formed in the respective pixel portions. Each pixel portion includes a color filter, a bottom electrode 12 formed on the substrate, part of a photoelectric conversion layer 14 which is formed on the bottom electrode 12 and functions as a photoelectric conversion portion, and part of a top electrode 16 formed on the photoelectric conversion portion (14).

In the following description of the example configuration which will be made with reference to Fig. 1, the light incidence side will be referred to by using the terms "top," "above," etc. and the side opposite to the light incidence side will be referred to by using the terms "bottom," "below," etc.

The configuration will be described below in a specific manner. The imaging device 10 has an n-type silicon substrate (hereinafter also referred to simply as a substrate) 1. A p-well region 2 is formed adjacent to the surface of the substrate 1 and plural n-type impurity diffusion regions 3 are formed in the well region 2. The plural impurity diffusion regions 3 are formed adjacent to the surface of the substrate 1 and arranged at prescribed intervals so as to correspond to the respective pixel portions (described later). Signal reading portions 4 for outputting signals corresponding to charges accumulated in the impurity diffusion regions 3, respectively, are formed adjacent to the surface of the well region 2 in the vicinity of the respective impurity diffusion regions 3.

The signal reading portions 4 constitute a circuit for converting charges stored in the respective impurity diffusion regions 3 into voltage signals and outputting the latter, and can be a known CCD or CMOS circuit.

An insulating layer 5 is laid on the surface of the substrate 1 adjacent to which the well region 2 is formed.

Plural bottom electrodes (pixel electrodes) 12 which are generally rectangular when viewed from above are formed on the insulating layer 5 so as to be arranged at prescribed intervals. The bottom electrodes 12 are electrically connected to the impurity diffusion regions 3 of the substrate 1 by connecting portions 6 which are formed in the insulating layer 5 and made of a conductive material.

A photoelectric conversion layer 14 is laid on the bottom electrodes 12, and a top electrode 16 which is a single layer and common to the pixel portions is formed on the photoelectric conversion layer 14. The top electrode 16 is made of a transparent conductive material because it is necessary to input light to the photoelectric conversion layer 14. It is preferable that, for example, the transparent conductive material has a transmittance of about 80% or more in a visible wavelength range of about 420 nm to about 660 nm.

In the imaging device 10, a bias voltage is applied between the top electrode 16 and the bottom electrodes 12 from a voltage supply portion (not shown) so that when charge-bearing carriers (holes and electrodes) are generated in the photoelectric conversion layer 14 by light incident thereon, holes are moved to the top electrode 16 and the electrons are moved to the bottom electrodes 12. The top electrode 16 serves as a hole collecting electrode and the bottom electrodes 12 serve as electron collecting electrodes. Although the following description will be directed to a case that charges are carried by electrodes, charges may be carried by holes.

The conductive materials of the top electrode 16 and the bottom electrodes 12 may be a metal, an alloy, a metal oxide, an electrically conductive compound, a mixture thereof, or the like. For example, the metal material may be an arbitrary combination selected from Li, Na, Mg, K, Ca, Rb, St, Cs, Ba, Fr, Ra, Sc, Ti, Y, Zr, Hf, V, Nb, Ta, Cr, Mo, W, Mn, Tc, Re, Fe, Ru, Os, Co, Rh, Ir, Ni, Pd, Pt, Cu, Ag, Au, Zn, Cd, Al, Ga, In, Tl, Si, Ge, Sn, Pb, P, As, Sb, Bi, Se, Te, Po, Br, I, At, B, C, N, F, O, S, and N.

The conductive materials of the top electrode 16 and the bottom electrodes 12 are selected taking into consideration the adhesion to the photoelectric conversion layer 14, electron affinity, ionization potential, stability, etc.

To form the top electrode 16 and the bottom electrodes 12, various methods are used depending on the material. For example, in the case of an ITO electrode(s), an electron beam method, sputtering, resistive heating evaporation, a chemical reaction method (e.g., sol-gel method), application of an ITO-dispersed material, or the like. In the case of an ITO electrode (s), UV-ozone treatment, plasma treatment, or the like may be performed.

Example conductive materials for the top electrode 16 are conductive metal oxides such as tin oxide, zinc oxide, indium oxide, and indium tin oxide (ITO), metals such as gold, silver, chromium, and nickel, mixtures or laminates of any of the above metals and a conductive metal oxide, inorganic conductive materials such as copper iodide, and copper sulfide, organic conductive materials such as polyaniline, polythiophene, and polypyrrole, a silicon compound, and laminates of any of the above materials and ITO. In particular, conductive metal oxides ITO, ZnO, and InO are preferable in terms of productivity, (high) conductivity, transparency, etc.

The material for the bottom electrodes 12 are only required to conductive, that is, it is not required to be transparent. However, the bottom electrodes 12 may also be made of a transparent electrode material in the case where it is necessary to transmit light to the substrate 1 side which is located under the bottom electrodes 12. In this case, it is preferable to use ITO as a transparent electrode material of the bottom electrodes 12 as in the case of the top electrode 16.

The photoelectric conversion layer 14 is made of a material that contains an organic material having a photoelectric conversion function. For example, the organic material may be any of various organic semiconductor materials that are used as photosensitive materials for electrophotography. Among those materials, a material containing a quinacridone skeleton and a material containing a phthalocyanine skeleton are particularly preferable from the viewpoints of high photoelectric conversion performance, superior color separation performance, high durability against long-term light illumination, and easiness of vacuum evaporation, etc.

The use of quinacridone as a material of the photoelectric conversion layer 14 makes it possible to absorb light in a green wavelength range and generate a corresponding amount of charge.

The use of zinc phthalocyanine as a material of the photoelectric conversion layer 14 makes it possible to absorb light in a red wavelength range and generate a corresponding amount of charge.

It is preferable that the organic material of the photoelectric conversion layer 14 contain at least one of a p-type organic semiconductor or an n-type organic semiconductor. For example, it is particularly preferable to use, as a p-type organic semiconductor or an n-type organic semiconductor, a quinacridone derivative, a naphthalene derivative, anthracene derivative, a phenanthrene derivative, a tetracene derivative, a pyrene derivative, a perylene derivative, or a fluoranthene derivative.

The photoelectric conversion layer 14 made of an organic material provides a larger light absorption coefficient for visible light than photoelectric conversion portions being photodiodes formed in a silicon substrate or the like. As a result, light incident on the photoelectric conversion layer 14 is absorbed by it more easily. With this property, even light that is incident obliquely on a portion of the photoelectric conversion layer 14 that belongs to a certain pixel portion is less prone to leak into adjacent pixel portions and most of the incident light is photoelectrically converted by the pixel portion of incidence. Both of increase in transmission efficiency and crosstalk suppression can thus be attained.

A planarization layer 18 is laid on the top electrode 16. Although not shown in any drawing, another insulating layer such as a nitride layer may be formed on the top electrode 16.

The color filter layer CF is formed on the planarization layer 18. As shown in Fig. 2, the color filter layer CF includes sets of color filters 21r, 21g, and 21b which transmit light components in different wavelength ranges.

The color filter 21r, which is denoted by R in Fig. 2, functions as a red light color filter which transmits a component of incident light in a red wavelength range. The color filter 21g, which is denoted by G in Fig. 2, functions as a green light color filter which transmits a component of incident light in a green wavelength range. The color filter 21b, which is denoted by B in Fig. 2, functions as a blue light color filter which transmits a component of incident light in a blue wavelength range.

One color filter which is a color filter 21r, 21g, or 21b is included in each pixel portion, and the color filters 21r, 21g, and 21b are arranged in a color pattern such as the Bayer arrangement according to the arrangement of the pixel portions. In the example of Fig. 2, one color filter 21r, two color filters 21g, and one color filter 21b are provided in four pixel portions. However, the arrangement of the color filters 21r, 21g, and 21b is not limitedto this arrangement andmaybemodifiedarbitrarily.

In the color filter layer CF, a separation wall 22 for separating the color filters 21r, 21g, and 21b from each other is formed between adjoining ones of the color filters 21r, 21g, and 21b thus arranged. The separation wall 22 is formed approximately in grid form in a plan view (see Fig. 2) so as to surround the color filters 21r, 21g, and 21b individually.

The separation wall 22 is made of a transparent material that is smaller in refractive index than the color filters 21r, 21g, and 21b.

It is preferable that the dimension (hereinafter referred to as thickness) t of the separation wall 22 which corresponds to the interval between adjoining ones of the color filters 21r, 21g, and 21b be 0.05 to 0.2 µm. To increase the photodetection area of each pixel portion, it is desirable that the thickness t of the separation wall 22 be as small as possible. However, the above range is preferable when suitability for a manufacturing process is taken into consideration.

The imaging device 10 is a stack-type imaging device in which the photoelectric conversion layer 14 is laid over the substrate 1. In the imaging device 10, the distance d between the color filter layer CF and the photoelectric conversion layer 14 can be set shorter than conventional imaging devices in which charge transfer channels are formed in a substrate in which photodiodes are formed and a color filter layer is formed on the charge transfer channels with a planarization layer etc. interposed in between. More specifically, the distance d is measured from the bottom surface of the color filter layer CF and the top surface of the photoelectric conversion layer 14. The configuration of the imaging device 10 makes it possible to set the distance d smaller than or equal to 3 µm.

When viewed from the light incidence side of the imaging device 10, each pixel portion which includes a color filter 21r, 21g, or 21b and a surrounding portion of the separation wall 22 assumes an approximately square shape each of whose sidelines measures about 1.4 µm. This size will be referred to as a pixel portion size.

When the dimensions of each member of the imaging device 10 is made comparable with the wavelengths of incident light, the wave-like behavior of the incident light becomes dominant rather than the behavior as determined by the geometrical optics. For example, where the pixel portion size is about 1.4 µm, the pixel portion size is comparable with the wavelengths of incident light and hence the incident light behaves in a wave-like manner in the imaging device 10, which would be a cause of reduction in transmission efficiency and increase in crosstalk. The influences of the diffraction and interference due to the wave-like behavior of incident light increase as the distance d between the color filter layer CF and the photoelectric conversion layer 14 becomes longer.

In view of the above, in the imaging device 10, the separation wall 22 is formed between the color filters 21r, 21g, and 21b of the color filter layer CF. The separation wall 22 positively gathers light that passes each of the color filters 21r, 21g, and 21b and reaches the photoelectric conversion layer 14. This makes it possible to suppress the reduction in transmission efficiency and the increase in crosstalk even if incident light behaves in a wave-like manner. In the case of a stack-type imaging device, it is preferable that the distance d be smaller than or equal to 0.8 µm when the pixel portion size is set smaller than or equal to 1.4 µm.

Next, it will be shown that the transmission efficiency can be increased by forming the separation wall in the color filter layer of an imaging device. The following description will be directed to imaging devices having the same configuration as the above-described imaging device 10.

The wavelength of incident light was 450 nm and the angle of light incidence on the light-incidence-side surface of the color filter layer of the imaging device was 0°. The polarization direction of incident light was set to a middle state between a p-wave and an s-wave. The pixel portion size was 1.0 µm (≅ 1.005 µm) and the thickness t of the separation wall was 0.1 µm (air layer). The thickness of the color filter layer (each color filter) was 0. 5 µm and the corresponding height of the separation wall was also 0.5 µm.

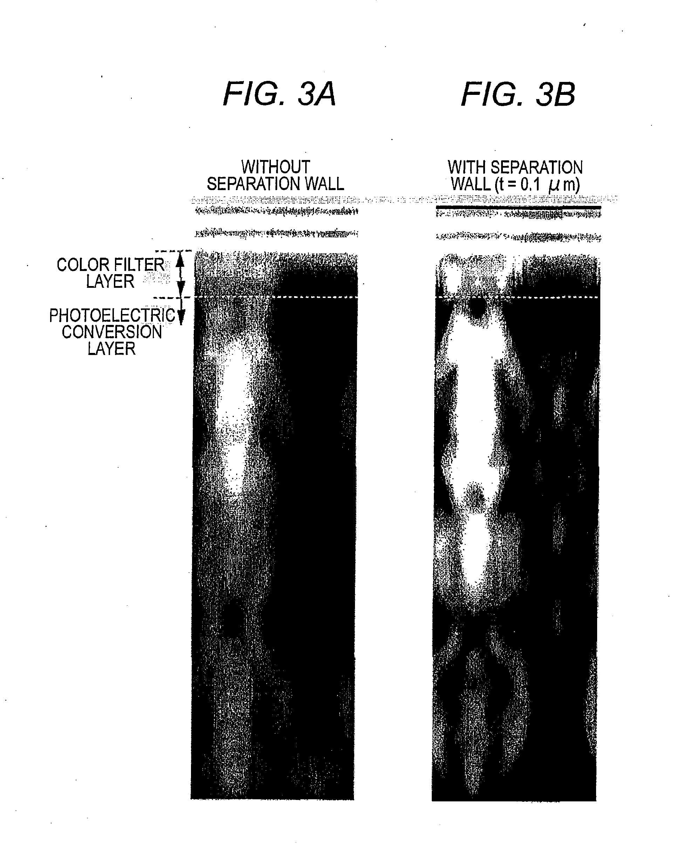

Figs. 3A and 3B show optical energy profiles in photoelectric conversion portions that were obtained when light was input. Fig. 3A shows a case of an imaging device with no separation wall and Fig. 3B shows a case of an imaging device with the separation wall. Each of Figs. 3A and 3B is a sectional view of two adjoining pixel portions; the left-hand pixel portion includes a color filter that transmits blue light and the right-hand pixel portion includes a color filter that transmits green light. In Figs. 3A and 3B, white portions are portions where the optical energy is high (proportional to the degree of whiteness). It is seen that in the imaging device of Fig. 3B the optical energy is more concentrated around the center line of the pixel portion including the blue color filter than in the imaging device of Fig. 3A because of addition of parts of the incident light that are reflected by the separation wall.

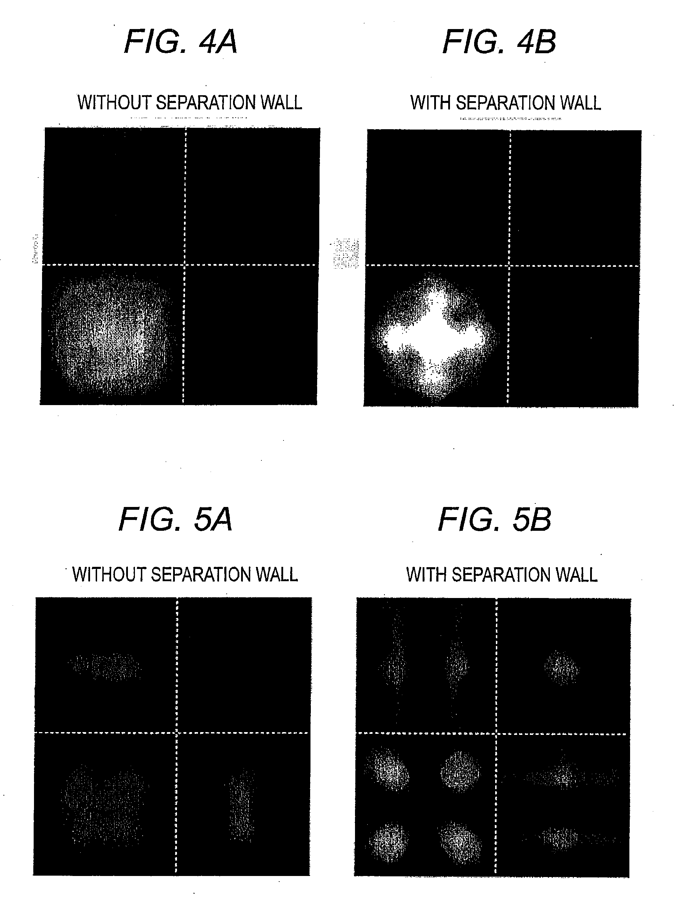

Figs. 4A and 4B show optical energy distributions that were obtained in cross sections taken at a position that was 0.4 µm below the bottom surfaces of the color filters in the respective imaging devices. Attention will mainly be paid to the optical energy distribution in the bottom-left pixel portion including the blue color filter among the four pixel portions (two pixel portions are arranged in each of the vertical and horizontal directions) shown in each of Figs. 4A and 4B.

It is seen that in the imaging device of Fig. 4B the optical energy is concentrated in a central portion of the pixel portion because the separation wall causes effective use of light diffraction and interference. On the other hand, in the imaging device of Fig. 4A, the optical energy is spread to a peripheral portion of the pixel portion and hence is low in the entire pixel portion because light diffraction and interference cannot be utilized effectively and hence the light cannot be gathered.

Figs. 5A and 5B show optical energy distributions that were obtained in cross sections taken at a position that was 5.0 µm below the bottom surfaces of the color filters in the respective imaging devices. It is seen that in a region that is distant from the color filter the efficiency of light collection is somewhat higher in the imaging device with the separation wall (Fig. 5B) than in the imaging device with no separation wall (Fig. 5A) but light cannot be gathered and leaks into adjacent pixel portions irrespective of presence/absence of the separation wall.

The influences of the presence/absence of the separation wall on the transmission efficiency were studied by varying the pixel portion size and the distance from the color filter layer by the same method as described above. Imaging devices used were the same as the above-described imaging device 10 unless otherwise specified. Results of the study are summarized in the following tables.

**[Table 1]**

| Pixel portion size (µm square) | With separation wall | Without separation wall | Transmission efficiency ratio |
|---|---|---|---|
| 1.005 | 76% | 58% | 130% |
| 1.4025 | 77% | 63% | 122% |
| 1.7025 | 77% | 65% | 118% |
| 2.16 | 77% | 67% | 114% |

Table 1 shows measurement results of the transmission efficiency of imaging devices which had pixel portion sizes 1.005 µm square, 1.4025 µm square, 1. 7025 µm square, and 2.16 µm square and had or did not have the separation wall. The measurements were performed at a position that was 0.5 µm below the bottom surface of the color filter layer. Table 1 also shows transmission efficiency ratios (the transmission efficiency ratio is the ratio of the transmission efficiency of an imaging device with the separation wall to that of a corresponding imaging device with no separation wall; this definition also applies to the following tables). A larger transmission efficiency ratio means a larger increase in transmission efficiency attained by the separation wall.

**[Table 2]**

| Pixel portion size (µm square) | With separation wall | Without separation wall | Transmission efficiency ratio |
|---|---|---|---|
| 1.005 | 64% | 52% | 122% |
| 1.4025 | 72% | 60% | 120% |
| 1.7025 | 75% | 63% | 119% |
| 2.16 | 75% | 66% | 115% |

Table 2 shows measurement results of the transmission efficiency of the imaging devices which had pixel portion sizes 1.005 µm square, 1.4025 µm square, 1.7025 µm square, and 2.16 µm square and had or did not have the separation wall. The measurements were performed at a position that was 1.0 µm below the bottom surface of the color filter layer. Table 2 also shows transmission efficiency ratios.

**[Table 3]**

| Pixel portion size (µm square) | With separation wall | Without separation wall | Transmission efficiency ratio |
|---|---|---|---|
| 1.005 | 33% | 27% | 118% |
| 1.4025 | 57% | 51% | 111% |
| 1.7025 | 58% | 50% | 115% |
| 2.16 | 64% | 57% | 111% |

Table 3 shows measurement results of the transmission efficiency of the imaging devices which had pixel portion sizes 1.005 µm square, 1.4025 µm square, 1.7025 µm square, and 2.16 µm square and had or did not have the separation wall. The measurements were performed at a position that was 5.0 µm below the bottom surface of the color filter layer. Table 3 also shows transmission efficiency ratios.

The results of the study show that the optical energy can be concentrated more efficiently in the imaging devices with the separation wall than in the imaging devices with no separation wall irrespective of the pixel portion size and the distance from the bottom surface of the color filter layer, as a result of which the transmission efficiency ratios are larger than 100%. The transmission efficiency ratio is larger when the pixel portion size is smaller or the measurement position is closer to the bottom surface of the color filter layer. Furthermore, crosstalk can be suppressed more in the imaging devices with the separation wall than in the imaging devices with no separation wall.

Next, other imaging devices having different configurations than the above-described imaging device 10 will be described. In the following description, members etc. having the same (or equivalent) structure and function as corresponding members etc. described above will be given the same reference symbols in the drawings as the latter and descriptions for those members etc. will be simplified or omitted.

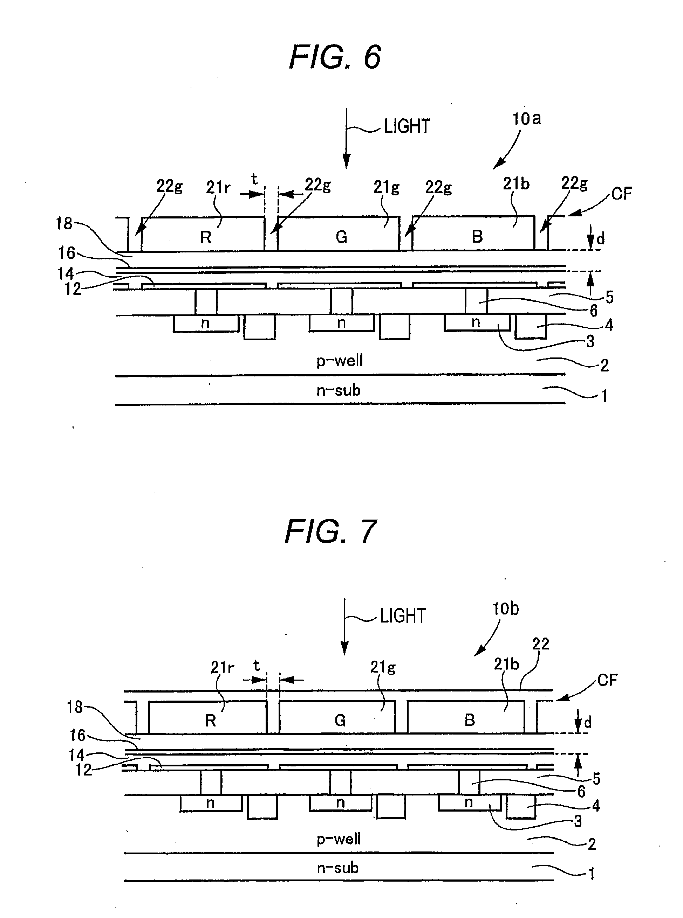

Fig. 6 is a schematic sectional view showing an example configuration of another imaging device 10a. As shown in Fig. 6, in the imaging device 10a, the separation wall 22 which separates the color filters 21r, 21g, and 21b from each other is an air layer 22g. The refractive index of air which is approximately equal to 1 is sufficiently smaller than that of the material of each of the color filters 21r, 21g, and 21b. As a result, the air layer 22g enhances the effect of reflecting light that is incident on each of the color filters 21r, 21g, and 21b, whereby the light is gathered in the corresponding portion of the underlying photoelectric conversion layer 14.

Fig. 7 shows another imaging device 10b in which the separation wall 22 which separates the color filters 21r, 21g, and21b fromeach other is an integral member which not only occupies the spaces between the color filters 21r, 21g, and 21b but also covers their top surfaces.

Where the top surfaces of the color filters 21r, 21g, and 21b are not protected by any layer, it is highly probable that the color filters 21r, 21g, and 21b are damaged in processes (e.g., pad hole formation and dicing) that are executed after formation of devices on a wafer in a manufacturing process. Forming the separation wall 22 so that it covers the top surfaces of the color filters 21r, 21g, and 21b makes it possible to prevent the color filters 21r, 21g, and 21b from being damaged in a manufacturing process and to increase the incident light transmission efficiency. Since the layer that covers the top surfaces of the color filters 21r, 21g, and 21b is part of the separation wall 22 and hence is made of the same material as the other part of the separation wall 22, the number of steps of a manufacturing process can be decreased.

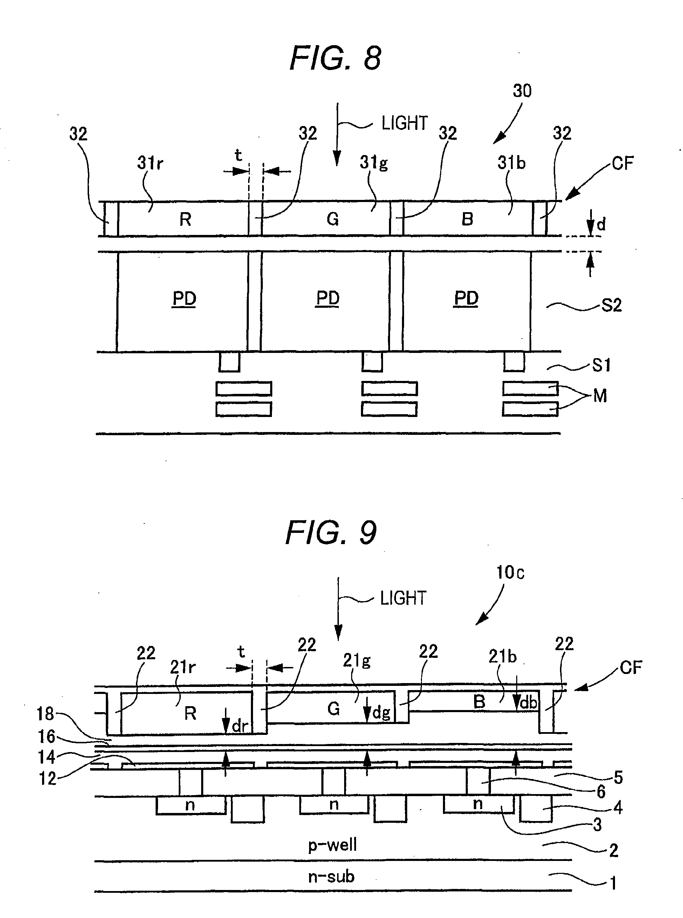

Fig. 8 shows the configuration of a back-illumination-type imaging device 30. In the imaging device 30, silicon photodiodes PD which are formed in a substrate S2 such as a silicon substrate function as photoelectric conversion portions. A color filter layer CF is formed on the light-incidence-side surface of the substrate S2 with a planarization layer, an insulating layer, etc. interposed in between. As in the above-described imaging devices, the color filter layer CF includes color filters 31r, 31g, and 31b. A separation wall 32 which separates the color filters 31r, 31g, and 31b from each other is formed between the color filters 31r, 31g, and 31b. It is preferable that the thickness t of the separation wall 32 be in a range of 0.05 to 0.2 µm for the same reasons as in the above-described imaging devices.

In the imaging device 30, a circuit substrate S1 is provided on the side of the substrate S2 that is opposite to its surface on which the color filter layer CF is formed. The circuit substrate S1 is provided with a signal reading circuit for reading out, as signals, charges generated by the silicon photodiodes PD. In Fig. 8, character M denotes wiring layers.

Each pixel portion includes a silicon photodiode which is formed in the substrate S2. The silicon photodiodes PD of the pixel portions absorb light beams that have passed through the color filters 31r, 31g, and 31b of the respective pixel portions and generate charges through photoelectric conversion. The generated charges are read out by the wiring layers M formed in the circuit substrate S1.

In the imaging device 30, it is not necessary to provide charge transfer electrodes etc. between the color filter layer CF and the silicon photodiodes PD, as a result of which the distance d between the color filter layer CF and the silicon photodiodes PD can be shortened.

With this configuration, forming the separation wall 32 between the color filters 31r, 31g, and 31b makes it possible to further increase the efficiency of light transmission in the silicon photodiode PD of each pixel portion. At the same time, crosstalk can be suppressed.

The imaging device 30 can be manufactured by an ordinary semiconductor process because the photoelectric conversion portions are the silicon photodiodes PD.

In the imaging device 30 of Fig. 8, since the signal reading portions and the wiring layers are provided on the side that is opposite to the light incidence side, the color filter layer CF which is provided on the light incidence side can be made sufficiently close to the photoelectric conversion portions. It is really possible to make the distance between the color filter layer CF and the photoelectric conversion portions shorter than or equal to 3 µm. As long as the signal reading portions and the wiring layers are provided on the side that is opposite to the light incidence side as in the above example, the configuration of the imaging device is not limited to the stack type or the back illumination type and can be modified as appropriate within such a range that the pixel portions can be separated from each other indirectly by the separation wall which is provided in the color filter layer.

An imaging device 10c shown in Fig. 9 is configured in such a manner that the distance between the color filter and the photoelectric conversion portion is varied on a pixel-portion-by-pixel-portion basis according to the wavelength of light that passes through the color filter. More specifically, the color filters 21r, 21g, and 21b are given different thicknesses according to wavelengths of light beams that pass through the color filters 21r, 21g, and 21b, respectively, as a result of which the distances dr, dg, and db between the photoelectric conversion layer 14 and the color filters 21r, 21g, and 21b, respectively, are different from each other on a pixel-portion-by-pixel-portion basis.

Where the optical density of each of the color filters 21r, 21g, and 21b can be adjusted, it is possible to make the red color filter 21r thickest, the blue color filter 21b thinnest, and the green filter 21g intermediate in thickness. The front surface of the color filter layer CF can be made flat by forming the back surface of the color filter layer CF stepwise on a pixel-portion-by-pixel-portion basis according to the thicknesses of the color filters 21r, 21g, and 21b. A portion of the separation wall 22 should exist between every adjoining pair of color filters. For example, a portion of the separation wall 22 that has the same height as the side surface of the thickest color filter 21r is provided between the color filters 21r and 21g. In this manner, the separation wall 22 can prevent light from leaking through the side surfaces of each of the color filters 21r, 21g, and 21b and entering other pixel portions.

The converging position of light that has passed through a color filter varies depending on its wavelength. For example, light having a long wavelength such as red light is converged at a position that is relatively close to the color filter and light having a short wavelength such as blue light is converged at a position that is relatively distant from the color filter. Furthermore, the range where the optical energy is high depends on the wavelength of light. These factors can be compensated for by varying the distances dr, dg, and db between the photoelectric conversion layer 14 and the color filters 21r, 21g, and 21b on a pixel-portion-by-pixel-portion basis by giving different thicknesses to the color filters 21r, 21g, and 21b as in the configuration being discussed. That is, the distance dg between the green color filter 21g and the photoelectric conversion layer 14 is longer than the distance dr between the red color filter 21r and the photoelectric conversion layer 14, and the distance db between the blue color filter 21b and the photoelectric conversion layer 14 is longer than the distance dg between the green color filter 21g and the photoelectric conversion layer 14. As a result, in the photoelectric conversion layer 14, more optical energy can be absorbed by each pixel portion and the transmission efficiency can be increased further.

Although the imaging device 10c of Fig. 9 is of the stack type, also in a back-illumination-type imaging device the distance between the color filter and the photodiode can be varied on a pixel-portion-by-pixel-portion basis according to the wavelength of light that passes through the color filter. In this case, the distance between the color filter and the photodiode maybevariedonapixel-portion-by-pixel-portionbasisbyvarying the thickness of the color filter.

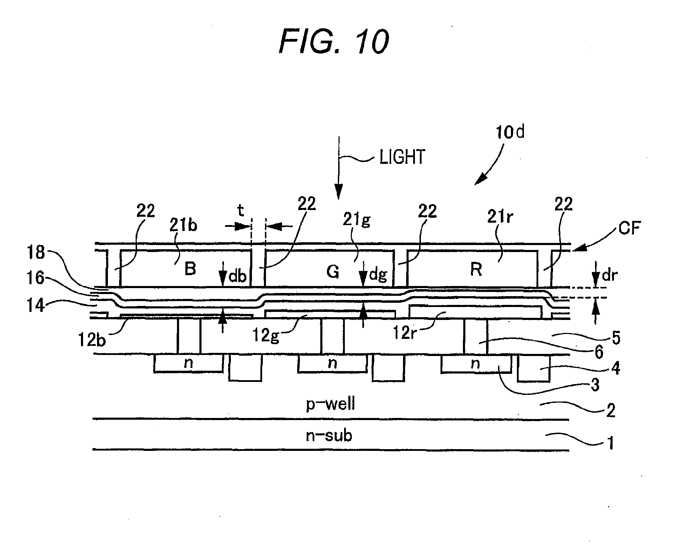

An imaging device 10d shown in Fig. 10 is based on the same concept as the imaging device 10c of Fig. 9. That is, the distance between the color filter and the photoelectric conversion portion is varied on a pixel-portion-by-pixel-portion basis according to the wavelength of light that passes through the color filter.

In this example configuration, the distances between the photoelectric conversion layer 14 and the respective color filters 21r, 21g, and 21b are made different from each other on a pixel-portion-by-pixel-portion basis by giving different thicknesses to the bottom electrodes 12r, 12g, and 12b according to the wavelengths of light beams that pass through the color filters 21r, 21g, and 21b. More specifically, the bottom electrode 12b of the pixel portion including the blue color filter 21b is thinnest, and the bottom electrode 12r of the pixel portion including the red color filter 12r is thickest, and the bottom electrode 12g of the pixel portion including the green color filter 12g has an intermediate thickness. As a result, it becomes possible to make the distance db between the blue color filter 21b and the photoelectric conversion layer 14 longest, the distance dr between the red color filter 21r and the photoelectric conversion layer 14 shortest, and the distance dg between the green color filter 21g and the photoelectric conversion layer 14 intermediate.

In the imaging devices 10c and 10d of Figs. 9 and 10, the pixel portions including the red, green, and blue color filters 21r, 21g, and 21b are made red, green, and blue pixel portions, respectively. In this case, establishing a relationship dr ≤ dg ≤ db for the distances dr, dg, and dr corresponding to the red, green, and blue pixel portions, respectively, makes it possible to more efficiently gather light in a portion of the photoelectric conversion layer 14 that belongs to each pixel portion and to allow the separation wall 22 to further increase the transmission efficiency.

The above descriptions of the respective example configurations disclose the following items:
(1) An imaging device comprising:
   plural pixel portions comprising color filters and photoelectric conversion portions, respectively, each of the photoelectric conversion portions generating charge according to light incident thereon, the color filters being provided on a light incidence side of the respective photoelectric conversion portions, a distance between the photoelectric conversion portions and the color filters being shorter than or equal to 3 µm; and
   a separation wall which is provided between adjoining ones of the color filters and separates the color filters from each other.
(2) The imaging device according to item (1), wherein the pixel portions include respective bottom electrodes formed on a substrate, a photoelectric conversion layer formed on the bottom electrodes, and a top electrode formed on the photoelectric conversion layer, the imaging device further comprising:
   signal reading portions which are formed in the substrate and output signals that correspond to charges captured by the bottom electrodes, respectively.
(3) The imaging device according to item (1), wherein the pixel portions include respective silicon photodiodes formed in a substrate, the imaging device further comprising:
   signal reading portions which are formed in the substrate on a side opposite to a surface of the substrate on which the color filters are formed, and which output signals that correspond to charges generated by the silicon photodiodes, respectively.
(4) The imaging device according to any one of items (1) to (3), wherein the separation wall is an air layer.
(5) The imaging device according to any one of items (1) to (3), wherein the separation wall is made of a transparent material that is smaller in refractive index than the color filters.
(6) The imaging device according to any one of items (1) to (5), wherein the separation wall has a refractive index that is smaller than or equal to 1.4.
(7) The imaging device according to any one of items (1) to (6), wherein a dimension of the separation wall that corresponds to an interval between adjoining ones of the color filters is in a range of 0.05 µm to 0.2 µm.
(8) The imaging device according to any one of items (5) to (7), further comprising a layer that is formed on the color filters and made of the same material as the separation wall.
(9) The imaging device according to any one of items (1) to (8), wherein the distance between the photoelectric conversion portion and the color filter varies on a pixel-portion-by-pixel-portion basis according to the wavelength of light that passes through the color filter.
(10) The imaging device according to any one of items (1) to (9), wherein the distance between the photoelectric conversion portion and the color filter is varied on a pixel-portion-by-pixel-portion basis by varying the thickness of the color filter according to the wavelength of light that passes through the color filter.
(11) The imaging device according to any one of items (1), (2) and (4) to (10), wherein the distance between the photoelectric conversion portion and the color filter is varied on a pixel-portion-by-pixel-portion basis by varying the thickness of the bottom electrode according to the wavelength of light that passes through the color filter.
(12) The imaging device according to any one of items (1) to (11), wherein the color filter of each of the pixel portions is one of a red color filter which transmits light in a red wavelength range, a green color filter which transmits light in a green wavelength range, and a blue color filter which transmits light in a blue wavelength range, and a distance between the green color filter and the associated photoelectric conversion portion is longer than a distance between the red color filter and the associated photoelectric conversion portion and a distance between the blue color filter and the associated photoelectric conversion portion is longer than the distance between the green color filter and the associated photoelectric conversion portion.
(13) The imaging device according to any one of items (1), (2) and (4) to (12), wherein a material of the photoelectric conversion portions contains an organic material.

## Claims

1. An imaging device comprising:
a plurality of pixel portions comprising color filters and photoelectric conversion portions, respectively, each of the photoelectric conversion portions generating charge according to light incident thereon, the color filters being provided on a light incidence side of the respective photoelectric conversion portions, a distance between the photoelectric conversion portions and the color filters being shorter than or equal to 3 µm; and
a separation wall which is provided between adjoining ones of the color filters and separates the color filters from each other.

2. The imaging device according to claim 1, wherein the pixel portions comprise respective bottom electrodes formed on a substrate, a photoelectric conversion layer formed over the bottom electrodes, and a top electrode formed over the photoelectric conversion layer, the imaging device further comprising:
signal reading portions which are formed at the substrate and output signals that correspond to charges captured by the bottom electrodes, respectively.

3. The imaging device according to claim 1, wherein the pixel portions comprise respective silicon photodiodes formed in a substrate, the imaging device further comprising:
signal reading portions which are formed at the substrate on a side opposite to a surface of the substrate on which the color filters are formed, and which output signals that correspond to charges generated by the silicon photodiodes, respectively.

4. The imaging device according to any one of claims 1 to 3, wherein the separation wall is an air layer.

5. The imaging device according to any one of claims 1 to 3, wherein the separation wall is made from a transparent material that is smaller in refractive index than the color filters.

6. The imaging device according to any one of claims 1 to 5, wherein the separation wall has a refractive index that is smaller than or equal to 1.4.

7. The imaging device according to any one of claims 1 to 6, wherein a dimension of the separation wall that corresponds to an interval between adjoining ones of the color filters is in a range of from 0.05 µm to 0.2 µm.

8. The imaging device according to any one of claims 5 to 7, further comprising a layer that is formed over the color filters and made from the same material as the separation wall.

9. The imaging device according to any one of claims 1 to 8, wherein the distance between the photoelectric conversion portion and the color filter varies on a pixel-portion-by-pixel-portion basis according to the wavelength of light that passes through the color filter.

10. The imaging device according to any one of claims 1 to 9, wherein the distance between the photoelectric conversion portion and the color filter is varied on a pixel-portion-by-pixel-portion basis by varying the thickness of the color filter according to the wavelength of light that passes through the color filter.

11. The imaging device according to any one of claims 1, 2 and 4 to 10 , wherein the distance between the photoelectric conversion portion and the color filter is varied on a pixel-portion-by-pixel-portion basis by varying the thickness of the bottom electrode according to the wavelength of light that passes through the color filter.

12. The imaging device according to any one of claims 1 to 11, wherein the color filter of each of the pixel portions is one of a red color filter which transmits light in a red wavelength range, a green color filter which transmits light in a green wavelength range, and a blue color filter which transmits light in a blue wavelength range, and a distance between the green color filter and the associated photoelectric conversion portion is longer than a distance between the red color filter and the associated photoelectric conversion portion and a distance between the blue color filter and the associated photoelectric conversion portion is longer than the distance between the green color filter and the associated photoelectric conversion portion.

13. The imaging device according to any one of claims 1, 2 and 4 to 12, wherein the photoelectric conversion portions comprise an organic material.
